# DEMANDE DE BREVET EUROPEEN

(11) **EP 0 818 827 A1**
(43) Date de publication de la demande: **14.01.1998**
(21) Numéro de dépôt: 97401641.2
(22) Date de dépôt: 09.07.1997
(51) Int. Cl.: H01L 27/144

(54) **Photodétecteur à réponse perfectionnée, et capteur matriciel comportant une pluralité de tels photodétecteurs**

(30) Priorité: 12.07.1996 FR 9608730
(71) Demandeur: AUTOMOBILES PEUGEOT, 75116 Paris (FR); AUTOMOBILES CITROEN, 92200 Neuilly-sur-Seine (FR)
(72) Inventeur: Ni, Yang, 91940 Les Ulis (FR); Devos, Francis, 91620 La Ville du Bois (FR); Zhy, Yi-ming, 91940 Les Ulis (FR); Attia, Mondher, 92120 Montrouge (FR)
(74) Mandataire: Le Forestier, Eric

(57) **Abrégé**

Un photorécepteur comprend:
- une photodiode (PD) possédant une capacité de jonction (Cⱼ);
- des moyens (I_{clk}, V_{ref}) pour précharger ladite capacité de jonction en polarisant initialement la photodiode sous une tension inverse,
- des moyens (AO, C, I_{clk}, Iᵣₑₛₑₜ) d'acquisition d'une variable électrique (V_{Out}) représentative du courant produit dans la photodiode sous l'effet d'un rayonnement électromagnétique pendant une certaine durée d'exposition, et
- des moyens de cadencement (LC) pour commander les moyens de précharge et les moyens d'acquisition.

Selon l'invention, ladite variable électrique (V_{Out}) résulte du courant produit dans la photodiode pendant une première phase au cours de laquelle la diode est polarisée en inverse et pendant une seconde phase, succédant à la première, au cours de laquelle la diode est polarisée en direct.

Avantageusement, on prévoit des moyens pour faire varier le niveau de polarisation initiale.

## Description

La présente invention concerne d'une façon générale les capteurs de rayonnement à semi-conducteurs.

Les progrès des technologies électroniques intégrées offrent maintenant la possibilité d'associer l'acquisition d'un signal lumineux et le traitement au sein d'un même circuit matriciel, réalisé sur un même substrat semi-conducteur, communément appelé "rétine électronique".

Cependant, l'un des problèmes majeurs concernant l'exploitation des images acquises est lié aux très grandes variations possibles de la luminosité et du contraste des scènes en éclairage naturel. Ainsi, même en dehors du problème particulièrement critique de l'éblouissement total d'une cellule, qui est un cas extrême de perte de l'information et de diffusion de signal parasite sur les cellules voisines, il est clair que la complexité des circuits de traitement dépend notamment du rapport signal/bruit des signaux acquis.

Dans une telle rétine électronique, il est tout d'abord nécessaire de disposer de photorécepteurs de très bonne qualité si l'on souhaite obtenir une bonne qualité du signal traité.

Malgré quelques progrès récents, les rétines électroniques actuellement proposées sont encore largement imparfaites, soit parce que des circuits satisfaisants sur le plan de la qualité du traitement sont trop complexes et par conséquent, la surface du processeur associé à chaque pixel est trop grande, soit parce que leur dynamique est limitée, soit encore parce qu'en les dotant d'une dynamique plus étendue et figée, on réduit immanquablement la sensibilité.

On rappellera ici que les photorécepteurs à semiconducteurs convertissent un signal lumineux en signal électrique après un échantilionnage spatial, lié à la surface du capteur, et éventuellement temporel. Ainsi chaque photorécepteur peut intégrer le photosignal pendant un temps analogue à une durée d'exposition.

Un photorécepteur intégré doit avoir une bonne sensibilité pour les faibles éclairements mais aussi avoir une grande dynamique d'entrée (typiquement de 10⁵ à 10⁶).

Mais étant donné que la dynamique du signal électrique produit est généralement limitée, dans les systèmes analogiques, à un maximum de 10³, la sensibilité ne peut être constante sur toute la plage d'éclairements.

On va rappeler tout d'abord le principe d'un photorécepteur à jonction PN classique.

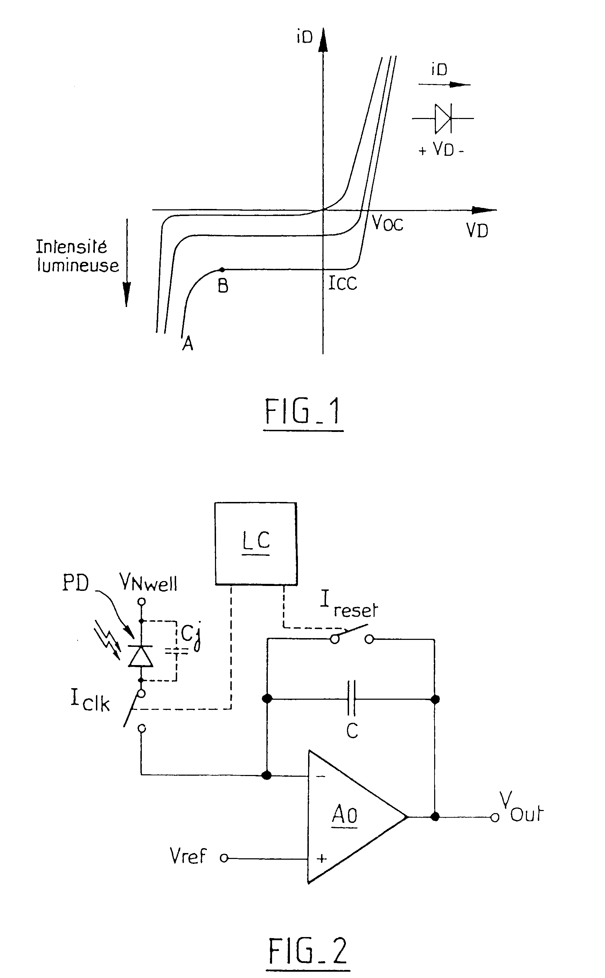

Les photons, dès qu'ils ont une énergie suffisante, peuvent directement créer des porteurs libres dans les matériaux semiconducteurs. Cette propriété permet la réalisation de deux types de dispositifs photodétecteurs, à savoir les photoconducteurs et les photodiodes. Les photodiodes de type CMOS présentent une bonne sensibilité en lumière visible et sont choisies dans de nombreuses applications de la vision artificielle. Les porteurs utiles y sont créés dans la zone de charge d'espace, ou en son voisinage immédiat quand elle est polarisée en inverse. En effet les électrons et les trous créés sont ainsi séparés par le champ électrique présent dans la zone, avant de pouvoir se recombiner. Ils contribuent alors au courant inverse de la jonction. On observe donc, sous éclairement, une augmentation en valeur absolue de ce courant inverse, proportionnel au flux lumineux incident. Le sens du champ électrique à la jonction étant le même quel que soit l'état de polarisation de celle-ci, cet effet est toujours observé. Concrètement, et comme le montre la figure 1, la caractéristique courant(i_{D})-tension(V_{D}) d'une jonction PN éclairée se trouve, dans la zone de polarisation inverse située entre les points B et Icc, décalée vers le bas par rapport à sa caractéristique dans l'obscurité. Dans cette zone, le photocourant, proportionnel à la lumière reçue, est le seul courant notable.

Le courant sortant peut être converti en tension de plusieurs manières. Si le courant est dirigé vers un condensateur (technique de l'intégration), la variation du potentiel obtenue après un temps d'exposition donné fournit une mesure exploitable de l'éclairement incident. Cette méthode, appelée méthode dynamique, a l'avantage d'une très bonne sensibilité, qui est en outre réglable par le temps d'exposition. Mais elle ne permet évidemment pas, pour un réglage donné, de couvrir toute la dynamique du signal d'entrée.

Il est connu par ailleurs qu'un photorécepteur doté d'une réponse lumière/tension logarithmique répondrait mieux aux besoins d'une grande dynamique, et l'on connaît notamment du document "Analog VLSI and Neural Systems", C. Mead, Addison-Wesley Publishing Company, 1989, des photorécepteurs, dits statiques, basés sur ce principe, selon lequel en cascadant un transistor MOS en faible inversion avec une photodiode éclairée, on peut récupérer un signal de tension qui est une fonction logarithmique du signal lumineux appliqué. Ce type de photorécepteur est théoriquement idéal. Mais il se révèle, en pratique, très sensible aux fluctuations technologiques qui, en régime de fonctionnement sous-le-seuil, se traduisent par une dispersion importante des caractéristiques de conduction. De plus, la fonction de conversion logarithmique donne évidemment une amplitude du signal de sortie très faible (de l'ordre de 20 mV) pour des images naturelles de contraste normal.

Puisqu'une solution logarithmique ne résout pas idéalement le problème de la dynamique d'entrée, d'autres tentatives ont été effectuées, et l'on connaît notamment par le document "Adaptative Photoreceptor with Wide Dynamic Range", T. Delbrük et C. Mead, Proceedings of ISCAS'94, Londres, 1994, un circuit photorécepteur adaptatif présentant une très bonne sensibilité et une dynamique adaptative effectivement exploitable. Mais ce circuit est de structure assez complexe, et donc coûteux, son comportement reste très sensible à la technologie employée et surtout sa surface est importante, au détriment de la définition spatiale du capteur. Une dernière difficulté de ce photorécepteur connu réside dans l'interprétation du signal de sortie car, par la nature passe-haut non-linéaire et non-stationnaire du procédé employé, son spectre temporel est largement modifié.

La présente invention vise à proposer une cellule photoréceptrice intégrable en technologie CMOS à très haute intégration, c'est-à-dire avec une très bonne définition spatiale d'image, qui soit extrèmement simple, tout en présentant une dynamique étendue et une sensibilité satisfaisante.

Un autre objet de l'invention est de proposer une cellule dont la sensibilité puisse être programmée de façon simple pour couvrir une plage d'éclairements de dynamique étendue, et qui en outre présente un comportement "anti-éblouissement" naturel tout à fait avantageux.

Ainsi la présente invention propose tout d'abord un photorécepteur, comprenant :
- une photodiode possédant une capacité de jonction;
- des moyens pour précharger ladite capacité de jonction en polarisant initialement la photodiode sous une tension inverse,
- des moyens d'acquisition d'une variable électrique représentative du courant produit dans la photodiode sous l'effet d'un rayonnement électromagnétique pendant une certaine durée d'exposition, et
- des moyens de cadencement pour commander les moyens de précharge et les moyens d'acquisition,
caractérisé en ce que ladite variable électrique résulte du courant produit dans la photodiode pendant une première phase au cours de laquelle la diode est polarisée en inverse et pendant une seconde phase, succédant à la première, au cours de laquelle la diode est polarisée en direct.

De préférence, les moyens de cadencement sont aptes à faire varier la durée d'exposition, de manière à faire varier la pente de ladite variable électrique en fonction de l'éclairement pendant ladite première phase.

On prévoit aussi, avantageusement, des moyens pour faire varier la tension de polarisation initiale, de manière à faire varier le niveau de la variable électrique en fonction de l'éclairement pendant ladite seconde phase. Dans ce cas, la photodiode étant réalisée dans un caisson semi-conducteur, il est particulièrement avantageux de faire varier la tension de caisson.

Selon une forme de réalisation préférée des moyens d'acquisition, ceux-ci comprennent un circuit comportant :
un amplificateur,
une capacité de mémorisation branchée entre une entrée et la sortie de l'amplificateur,
un premier interrupteur commandé pour sélectivement court-circuiter les bornes de la capacité de mémorisation,
un second interrupteur commandé pour sélectivement relier la photodiode à ladite entrée de l'amplificateur, et
une source de tension de référence reliée à une autre entrée de l'amplificateur,
et ladite variable électrique est la tension de sortie dudit amplificateur.

L'invention propose également, selon un deuxième aspect, un capteur photosensible matriciel, caractérisé en ce qu'il comprend une pluralité de photodétecteurs tels que définis ci-dessus.

Préférentiellement, les photodétecteurs sont organisés en lignes et en colonnes, et il est prévu une pluralité de circuits d'acquisition respectivement associés aux photodétecteurs de chacune des lignes, et un circuit d'adressage de colonne destiné à affecter les circuits d'acquisition à des capteurs respectifs de chaque ligne appartenant à la même colonne.

Dans le cas où les circuits d'acquisition délivrent des tensions, on prévoit avantageusement des moyens pour convertir lesdites tensions en courants, ainsi qu'un circuit convertisseur pour convertir les courants successifs délivrés par les moyens de conversion en tensions successives.

Par ailleurs, lorsque les photodétecteurs individuels sont prévus dans des caissons, on prévoit de préférence des moyens pour faire varier une tension de caisson commune appliquée à ceux-ci.

De retour à la figure 1, on observe que, dès que la diode est polarisée en direct, c'est-à-dire entre les points Icc et Voc, le dispositif est équivalent à une photopile et le photocourant est complété par un courant direct non négligeable circulant en sens inverse du photocourant.

Selon la présente invention telle que définie ci-dessus, on utilise la photodiode dans un mode de conversion lumière/tension d'allure linéaire entre les points B et Icc, mais également dans cette prolongation entre Icc et Voc pour prolonger la fonction de conversion lumière/tension linéaire (mode photodiode classique) par une fonction de conversion d'allure généralement logarithmique (mode dit photopile ou photovoltaïque).

Plus précisément, en exploitant d'une certaine manière, précisée dans la suite, le photorécepteur sur l'ensemble de l'intervalle compris entre B et Voc, on peut à la fois obtenir une sensibilité satisfaisante aux faibles éclairements, à la faveur du régime linéaire, et conserver une grande dynamique globale du photorécepteur, tout en préservant la surface du circuit.

Il est à observer ici qu'une telle approche de la problématique dynamique/sensibilité ne semble jamais avoir été adoptée jusqu'à présent, pour des raisons que l'on peut résumer ci-dessous.

Tout d'abord, en régime photodiode dynamique, la tension de sortie dépend linéairement du temps d'exposition alors qu'en mode photopile, cette tension se stabilise à une valeur indépendante du temps d'exposition. D'autre part et surtout, il est bien connu qu'en mode photopile, une diode éclairée injecte des porteurs minoritaires dans le substrat et que rien ne peut empêcher une diffusion de ces porteurs à plusieurs pixels de distance, ce qui entraîne de graves pertes de contraste.

En outre, une éventuelle augmentation de dynamique n'est exploitable que si l'on résout avec une précision accrue les problèmes de diaphonie.

La présente invention telle que définie ci-dessus permet d'éviter ces inconvénients en plaçant chaque jonction PN exposée à la lumière dans un caisson séparé et ainsi d'isoler les différents photorécepteurs.

D'autres aspects, buts et avantages de la présente invention apparaîtront mieux à la lecture de la description détaillée suivante d'une forme de réalisation préférée de celle-ci, donnée à titre d'exemple non limitatif et faite en référence aux dessins annexés, sur lesquels :
la figure 1 est un diagramme illustrant différentes caractéristiques courant-tension d'une jonction PN pour différentes valeurs de l'intensité lumineuse incidente,
la figure 2 est un schéma du circuit de lecture d'une photodiode en mode charge,
la figure 3 est un schéma d'un circuit amplificateur à sept transistors pouvant être utilisé dans le circuit de lecture de la figure 2,
la figure 4 est une coupe transversale d'une photodiode utilisée dans un capteur selon l'invention,
la figure 5 représente le modèle analytique d'une photodiode utilisée dans un capteur selon l'invention,
les figures 6a et 6b illustrent de façon modélisée le comportement de la photodiode exploitée conformément à la présente invention,
la figure 7 illustre l'architecture générale d'une rétine prototype intégrée réalisée à l'aide de capteurs selon l'invention,
la figure 8 est un schéma d'un convertisseur courant/tension extérieur utilisé avec le circuit intégré de la figure 7,
les figures 9a et 9b sont des diagrammes illustrant le comportement d'un capteur selon l'invention dans un mode programmable,
les figures 10a et 10b sont des diagrammes illustrant le comportement d'un capteur selon l'invention avec différentes puissances lumineuses incidentes, et
les figures 11a et 11b illustrent par des diagrammes le comportement d'une rétine électronique selon l'invention en termes de diaphonie.

En référence maintenant à la figure 2, on va décrire comment réaliser l'exploitation continue d'une photodiode de type CMOS entre les modes linéaire et logarithmique illustrés sur la figure 1.

Pour lire le signal délivré par la photodiode, on utilise un circuit amplificateur de charge, éventuellement commun à plusieurs cellules adjacentes, l'une ce des cellules étant représentée sur la figure 2.

Ce circuit comporte, outre la photodiode PD, comportant de façon inhérente une capacité parasite de jonction Cj, un amplificateur opérationnel AO monté en intégrateur, avec une capacité de mémorisation C, un interrupteur de sélection et d'échantillonnage I_{clk} et enfin un interrupteur Iᵣₑₛₑₜ de remise à zéro (de décharge) de la capacité de mémorisation C.

Ce circuit comprend en outre une logique de commande LC appliquant aux interrupteurs I_{clk} et Iᵣₑₛₑₜ des signaux d'ouverture et de fermeture tels qu'on va les décrire ci-dessous. En outre une source de tension de référence Vref est appliquée à l'entrée non-inverseuse de AO, tandis que son entrée inverseuse est reliée à l'anode de la photodiode via l'interrupteur I_{clk} et à l'une des bornes du montage parallèle de la capacité de mémorisation C et de l'interrupteur Iᵣₑₛₑₜ, l'autre borne de ce montage étant reliée à la sortie de l'amplificateur opérationnel.

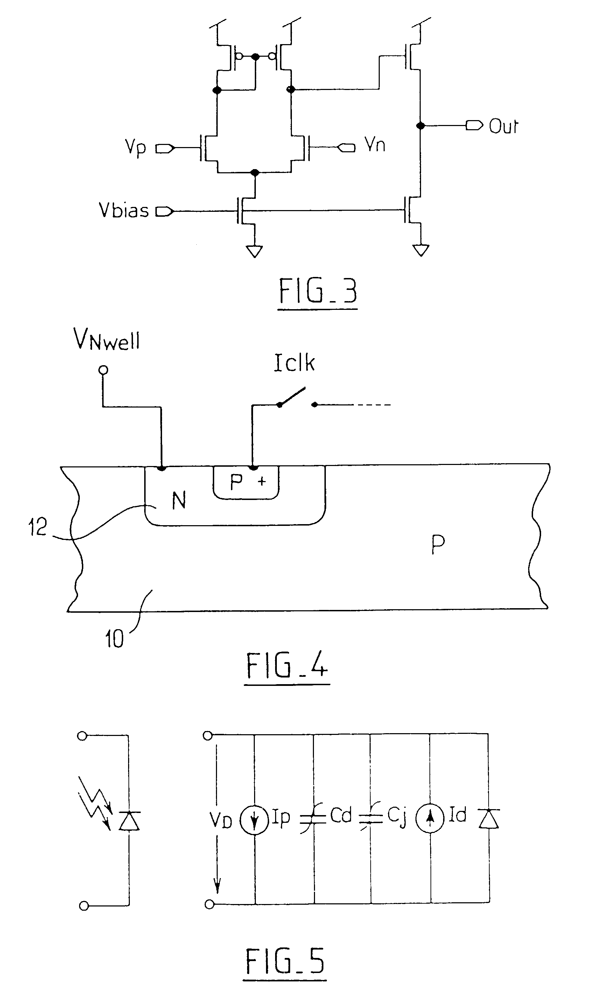

Le circuit de lecture de la figure 2 peut être réalisé de façon extrêmement compacte par l'intégration sur une puce semi-conductrice de sept transistors comme illustré sur la figure 3.

Par ailleurs, la figure 4 montre la structure semi-conductrice de la photodiode PD, de type classique en soi à l'exception du fait qu'elle est prévue dans un caisson 12 de type N lui-même formé dans un substrat 10 de type P, et que la tension de caisson, notée V_{Nwell}, peut être modifiée comme on le décrira en détail plus loin. Cette structure semi-conductrice à caisson permet de limiter la diaphonie entre cellules adjacentes.

On va décrire ci-dessous le comportement du circuit de la figure 2. On suppose initialement que la capacité de jonction naturelle Cj de la photodiode est polarisée en inverse à une valeur égale à V_{ref}-V_{Nwell}, V_{Nwell} ayant une valeur par exemple égale, en l'espèce, à la tension d'alimentation du circuit, et que les interrupteurs I_{clk} et Iᵣₑₛₑₜ sont ouverts.

On expose alors la photodiode à un rayonnement, et on laisse alors évoluer la tension aux bornes de la photodiode sous l'effet de la lumière pendant une certaine durée d'intégration Tₑₓₚ. Plus précisément, la photodiode est alors déchargée par le photocourant et la tension à ses bornes évolue vers des valeurs positives, à un rythme variable selon l'intensité lumineuse et le temps d'intégration.

Au cours de cette phase d'exposition, on ferme l'interrupteur Iᵣₑₛₑₜ pendant une durée suffisante pour décharger complètement la capacité de mémorisation C, puis on ouvre à nouveau Iᵣₑₛₑₜ.

On effectue alors, à un instant déterminé, une lecture "en charge" de la décharge qu'a subie la capacité de jonction Cj de la photodiode en fermant pendant un court instant l'interrupteur I_{clk}. Pendant cette phase, la capacité Cj est rechargée jusqu'à la valeur V_{ref}-V_{Nwell} par une charge inverse de la capacité C, si bien qu'à la fin de cette opération, on dispose dans la capacité C d'une valeur de charge qui est égale à celle qui a été nécessaire pour ramener Cj de sa charge courante à la charge correspondant à V_{ref}-V_{Nwell}, et qui par ailleurs est égale à C.(V_{Out}-V_{ref}).

On dispose ainsi sur la sortie V_{Out} du circuit de la figure 2 d'une tension représentative de la variation totale de charge du photorécepteur consécutive à l'exposition, c'est-à-dire de l'éclairement qui a été reçu par la photodiode pendant la période d'intégration.

A ce stade, Cj est chargée à la valeur V_{ref}-V_{Nwell} et un nouveau cycle peut commencer.

On comprend, comme on l'a expliqué en référence à la figure 1, que l'évolution de la tension recueillie est d'abord linéaire en temps et flux lumineux puis, au-delà d'un instant correspondant au point Icc de la figure 1, elle se stabilise vers une valeur d'équilibre qui est une fonction logarithmique du flux lumineux.

On va démontrer brièvement ci-dessous que ce mode d'exploitation de la photodiode est praticable en continu sur l'ensemble des modes photodiode et photopile.

La figure 5 illustre le modèle d'une photodiode PN, constitué par le montage parallèle d'une capacité de jonction Cj, d'une capacité de diffusion C_{d}, d'une source de courant inverse d'origine photonique Iₚ, et d'une source de courant direct I_{d}, ces sources étant contrôlées par la tension de jonction.

On pourrait démontrer que la valeur de la capacité de diffusion Cd est négligeable quand la jonction est polarisée en inverse, car la charge de porteurs minoritaires stockée est elle-même négligeable. En revanche, en conduction, cette capacité C_{d} augmente exponentiellement avec la tension de jonction.

Ainsi le calcul de la charge déplacée par le flux lumineux se sépare en deux cas:
1° le photorécepteur travaille en photodiode classique (dans la mesure où le temps d'exposition ou le flux lumineux sont suffisamment faibles);
2° le photorécepteur travaille initialement en photodiode classique, puis en mode photovoltaïque.

On pourait également démontrer par calcul que, pour toute durée d'intégration donnée, il existe une valeur maximum du niveau de luminosité incidente en deçà de laquelle la photodiode se comporte dans son premier mode de fonctionnement, et au delà de laquelle la photodiode entre dans son second mode de fonctionnement.

Dans ce second mode de fonctionnement, une partie de plus en plus grande des charges déplacées par le flux lumineux est perdue dans le courant direct de la photodiode, et seule une partie reste stockée dans la capacité de diffusion C_{d} de la photodiode.

On observera que cette partie de charge stockée est indépendante du temps d'exposition restant, mais on observe toutefois un changement de la tension globale.

On déduit de ce qui précède que la fonction de conversion totale du photorécepteur (tension V_{Out} en fonction de l'éclairement H) est une fonction linéaire de l'intensité lumineuse, mais en deux phases distinctes, avec une première phase dont la pente est réglable par le temps d'exposition et qui dure tant que l'intensité lumineuse est inférieure à une certaine valeur Hₘₐₓ (fonction de ce temps d'exposition). Ensuite, dès le passage en conduction de la diode, cette fonction devient indépendante du temps d'exposition, mais sa variation reste linéaire en éclairement avec une pente sensiblement plus faible que pendant la première phase.

Les deux phases linéaires sont séparées par un coude situé à la valeur Hₘₐₓ, valeur qui est fonction du temps d'exposition.

On notera également qu'en pratique, c'est seulement lorsque la tension de la jonction est non pas strictement nulle, mais supérieure à une certaine valeur de seuil V_{cr}, que le courant direct de diode atteint une certaine fraction, par exemple 1/3, de la valeur du photocourant, qui le rend non négligeable.

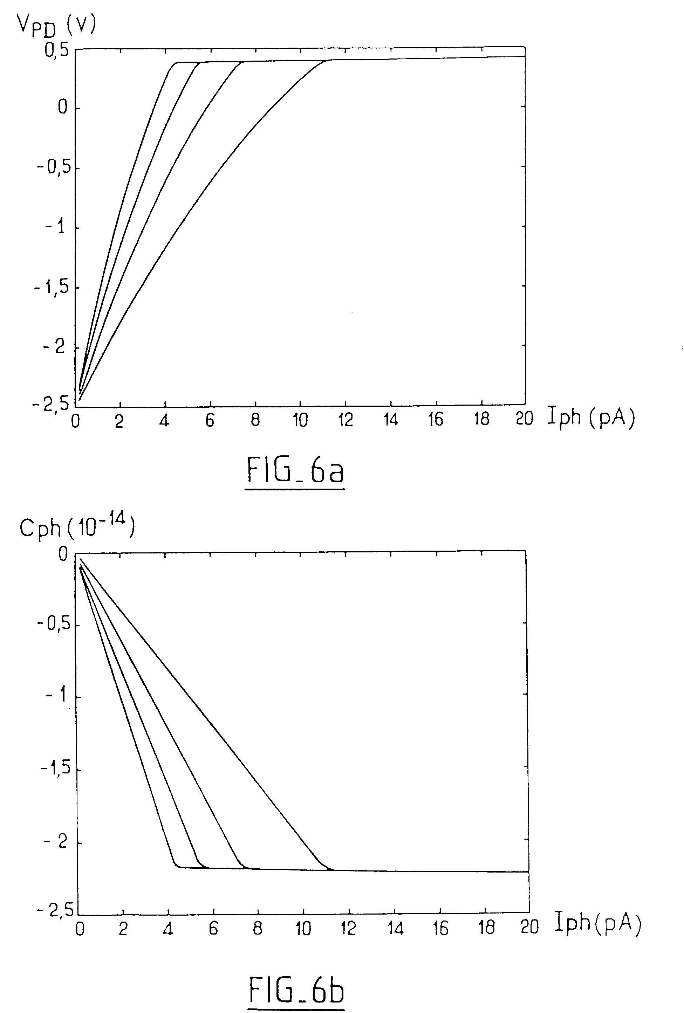

Les figures 6a et 6b illustrent ainsi l'allure de la réponse obtenue, c'est-à-dire de la relation entre la tension V_{PD} aux bornes de la photodiode et du courant photoélectrique Iₚₕ qui la traverse pour la figure 6a, et la relation entre la charge photoélectrique Cₚₕ et ce même courant Iₚₕ pour la figure 6b, et ceci pour différentes valeurs d'éclairement. L'échelle horizontale employée sur ces figures ne permet pas de restituer l'intégralité de la dynamique accessible, mais elles montrent clairement que l'évolution de la tension aux bornes du capteur est non linéaire alors que celle de la charge l'est bien davantage. On constate également qu'après le coude séparant les deux phases, la courbe de charge est rectiligne mais non horizontale.

Ainsi on a décrit ci-dessus un photorécepteur à deux phases de fonctionnement, qui est très sensible aux faibles intensités lumineuses et qui devient automatiquement moins sensible quand l'intensité lumineuse est supérieure à une valeur Hₘₐₓ. Si la position en "x" du coude, et donc la sensibilité de la première phase, est réglable en jouant sur la durée d'exposition, sa position en "y" était fixe dans cette forme de réalisation.

On va maintenant décrire une variante de réalisation qui est tout à fait intéressante en ce que qu'elle permet de faire varier la position du coude entre les deux phases selon la coordonnée "y", de manière à pouvoir ajuster la portion de de la plage de tension de sortie qui est affectée à la deuxième des phases d'entrée.

On pourrait démontrer à cet égard que la position en "y" du coude est une fonction non seulement du temps d'exposition, mais également des valeurs de V_{ref} et V_{Nwell}. Ainsi, à dynamique de lecture de sortie constante, il est avantageux de prévoir un capteur dans lequel on puisse ajuster le potentiel de cathode de la photodiode pour ainsi ajuster la position du coude en "y".

Or, comme on l'a décrit plus haut, la photodiode a été prévue avec une cathode réalisée sous la forme d'un caisson N (voir figure 4) afin de limiter la diaphonie, et l'on observe que le potentiel V_{NWell} de ce caisson peut être ajusté librement.

Ainsi, en modifiant la valeur de ce potentiel, il devient possible de programmer la sensibilité du photorécepteur et modifier la proportion de dynamique de sortie attribuée à chacune des deux phases de fonctionnement.

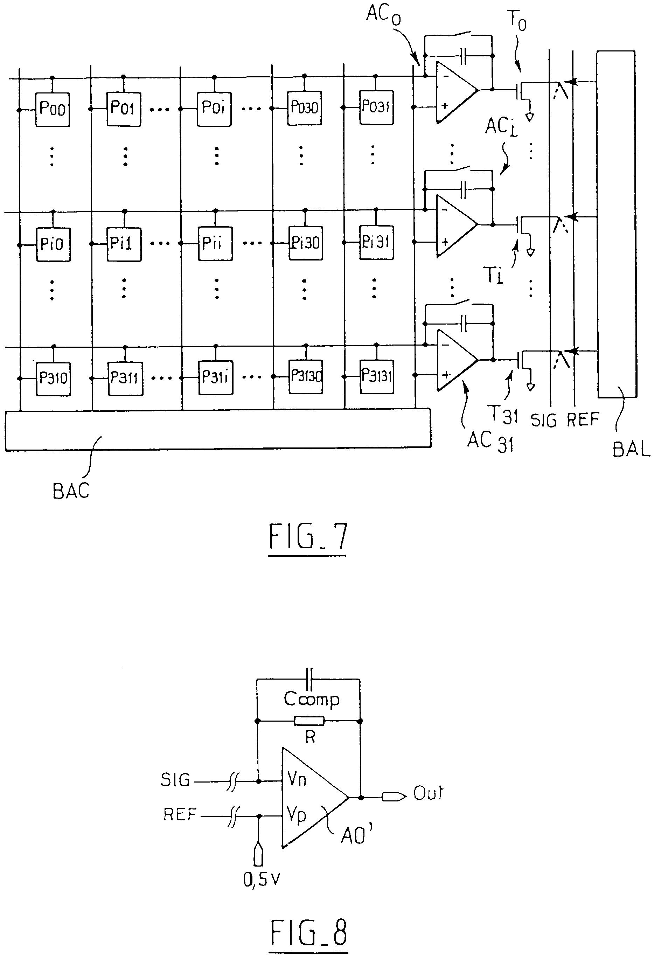

On va maintenant décrire en détail en référence à la figure 7 un réseau de photorécepteurs réalisés selon la présente invention. On a réalisé un circuit de test en technologie CMOS de 1µm afin d'une part de caractériser le fonctionnement réel de chaque photorécepteur individuel en termes de dynamique et de programmabilité de la sensibilité, et d'autre part de mesurer la diaphonie et l'homogénéité statistique de la sensibilité entre photorécepteurs d'une même matrice.

Ce circuit comporte une matrice de 32 lignes x 32 colonnes de photorécepteurs P₀₀ à P₃₁₃₁ à sensibilité programmable. La surface de chaque photorécepteur est en l'espèce de 30 µm x 30µm.

Dans chaque ligne de photorécepteurs Pᵢ₀ à Pᵢ₃₁, la sortie de chaque photorécepteur est échantillonnée vers un amplificateur de charge ACᵢ, tel que par exemple celui représenté sur la figure 2, à l'aide d'une adresse engendrée par un bloc d'adressage de colonne noté BAC. Cette adresse selectionne simultanément tous les photorécepteurs d'une colonne, les photorécepteurs d'une même ligne partageant le même amplificateur de charge.

Pour avoir une vitesse de balayage supérieure à une valeur de l'ordre du MHz, la sortie en tension de l'amplificateur de charge est convertie en courant à l'aide d'un transistor MOS en régime triode désigné par la référence Tᵢ, de façon connue en soi. Dans un tel montage, le courant obtenu est proportionnel à la tension de sortie de l'amplificateur de charge si le drain du transistor est polarisé suffisamment bas.

Les sorties individuelles des convertisseurs tension/courant Tᵢ sont aiguillées une par une sur une borne de sortie commune à l'aide d'un bloc d'adressage de ligne BAL, puis reconverties en tensions par un convertisseur courant-tension prévu de façon séparée. Pendant ce temps, les autres sorties de courant sont connectées à la ligne REF véhiculant la tension de référence V_{ref} décrite plus haut.

Le convertisseur courant-tension prévu à l'extérieur de la puce du circuit de la figure 7 est représenté sur la Figure 8. Il s'agit d'un convertisseur de type classique en soi. L'entrée positive Vp de l'amplificateur opérationnel AO' est maintenue à une tension fixe par exemple de 0,5V afin de polariser les transistors des convertisseurs tension/courant internes pour qu'ils opèrent dans leur mode triode. La capacité C_{comp} est une capacité de compensation.

On a réussi à réaliser un tel circuit sur une surface de substrat de 3384 µm x 3384 µm, la puce étant incorporée dans un boîtier approprié présentant une fenêtre pour l'entrée de la lumière.

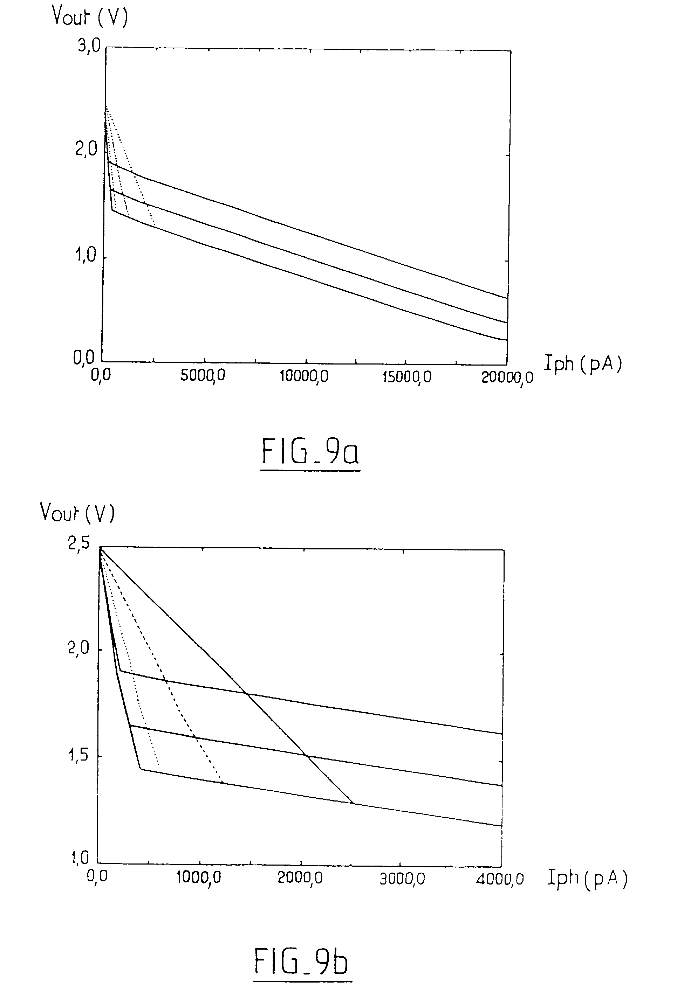

Les figures 9a et 9b montrent les résultats de tests de photosensibilité de ce circuit à sensibilité programmable avec différents temps d'exposition. Ces résultats sont présentés sous forme de courbes exprimant la tension de sortie V_{Out} du circuit des figures 7 et 8, en volts, en fonction du photocourant Iₚₕ exprimé en pico-ampères. La Figure 9a montre les résultats de tests dans des conditions de fortes illuminations, avec un axe de photocourant linéaire, et la Figure 9b est un agrandissement linéaire en x de la partie de faible photocourant. De gauche à droite sur ces figures, les quatre parties de courbes de forte pente représentent successivement des temps d'exposition de 2 ms, 1 ms, 0,5 ms et 0,25 ms. De haut en bas, les trois parties de courbes de faibles pentes représentent successivement des tensions de polarisation de caisson V_{NWell} de 3 V, 4 V et 5 V. Sur la Figure 9b, on observe clairement que la position du coude entre les deux phases de fonctionnement peut être contrôlée verticalement par la tension de caisson V_{NWell} du photorécepteur. En d'autres termes, la répartition entre les deux phases de fonctionnement peut effectivement être ajustée en jouant sur la tension de caisson du photorécepteur. On rappellera ici que le contrôle horizontal de ce coude s'effectue quant à lui en jouant sur la durée d'exposition.

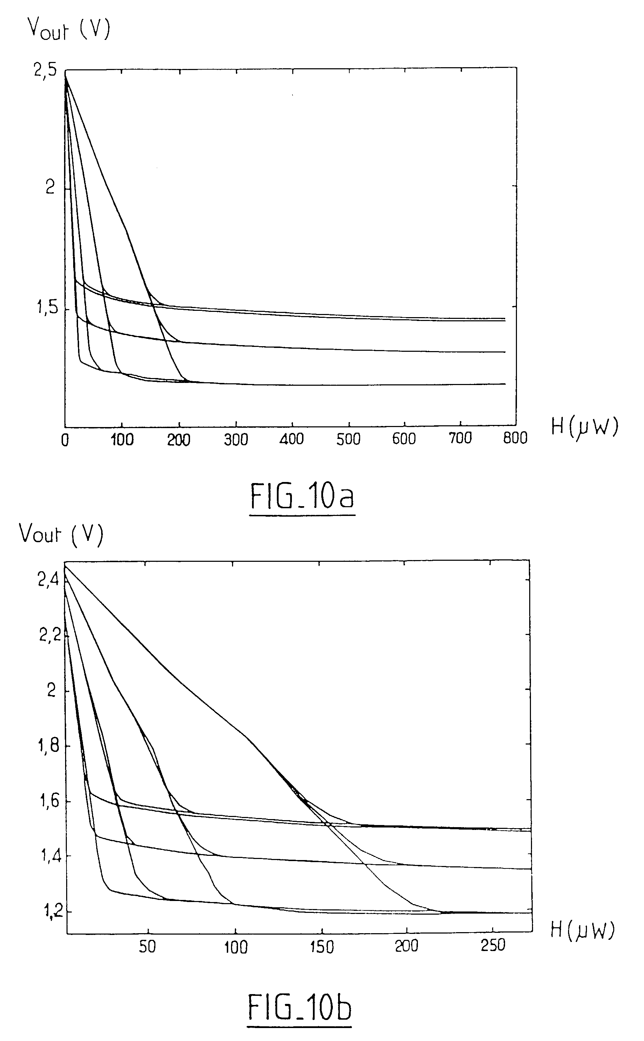

Les Figures 10a et 10b montrent graphiquement l'allure de la tension de sortie V_{Out} en fonction de la luminosité incidente H exprimée en microwatts. De la même manière que sur les figures 9a et 9b, la figure 10a donne les résultats pour les fortes luminosités tandis que la figure 10b est un agrandissement linéaire en x de la partie de plus faible photocourant. De gauche à droite sur ces figures, les courbes de forte pente représentent successivement des temps d'exposition de 8 ms, 4 ms, 2 ms et 1 ms. De haut en bas, les différentes courbes de pente plus faible correspondent à des tensions de polarisation du caisson de V_{Nwell} de 2,75V, 2,85V et 3V.

On peut vérifier sur les figures 10a et 10b que la sensibilité du photorécepteur est bien contrôlée par le temps d'exposition et par la tension des caissons des différents photorécepteurs de la matrice. Ainsi la dynamique des photorécepteurs est fortement élargie par rapport à une photodiode classique utilisée en mode linéaire et leur sensibilité est améliorée par rapport à une diode classique en mode logarithmique. La dynamique obtenue (de l'ordre de 10⁴ à 10⁵) est tout à fait satisfaisante.

On a expliqué plus haut que le problème de diaphonie entre les différents photorécepteurs voisins pouvait affecter la dynamique spatiale accessible, et que le fait de placer chaque photodiode de la matrice dans un caisson N spécifique était apte à sensiblement atténuer ce problème.

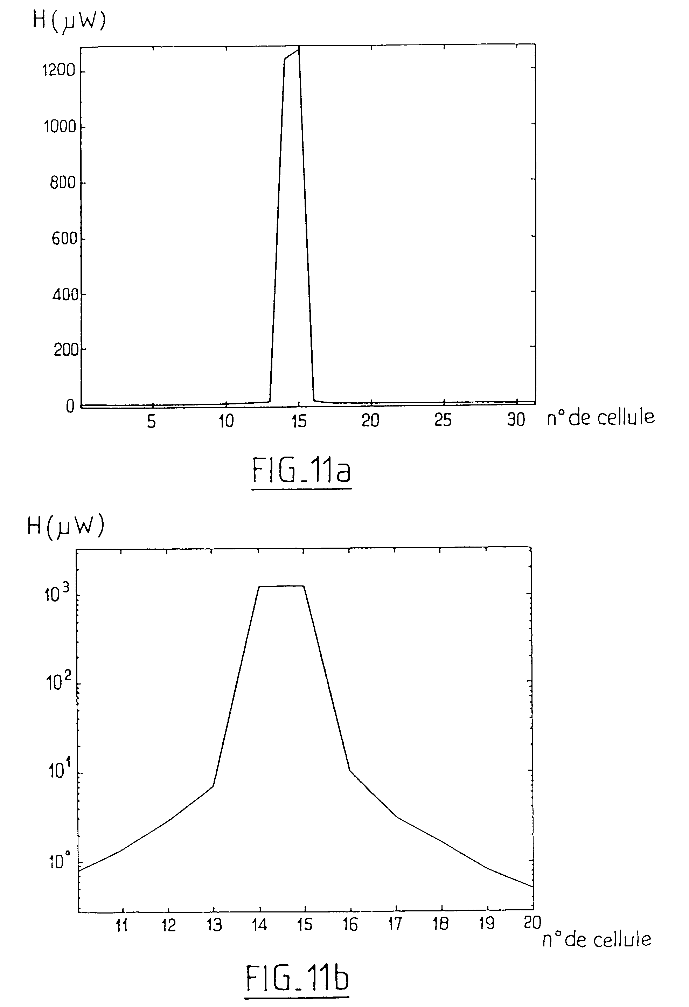

Un test de diaphonie a été effectué en éclairant deux cellules du centre de la matrice de la figure 7 (c'est-à-dire les 14ème et 15ème cellules d'une même ligne) et en laissant les autres cellules dans l'obscurité. La figure 11a illustre, par une courbe représentant le niveau du signal de luminosité H (linéaire et en microwatts) sur les différentes cellules de la ligne, identifiées par leur numéro, le résultat du test.

Pour mieux observer le phénomène, la figure llb est un agrandissement de la figure 11a avec un axe de la luminosité logarithmique. On peut déduire de ces mesures que la diaphonie entre photorécepteurs voisins est inférieure à environ 0,77%, cette valeur cumulant la diaphonie d'origine électronique et la probable diaphonie d'origine optique résultant de la diffusion de la lumière liée, entre autres, aux réflexions parasites de l'optique de projection.

Ainsi l'on a décrit un photorécepteur de même structure qu'une photodiode classique mais dont la lecture est réalisée selon un "mode charge". Ainsi sa dynamique de sortie s'en trouve agrandie par l'utilisation de la partie photovoltaique de la réponse et surtout, sa courbe de sensibilité est programmable en faisant varier, outre le temps d'exposition, la tension de polarisation du caisson.

Bien entendu, la présente invention n'est nullement limitée à la forme de réalisation décrite et représentée, mais l'homme du métier saura y apporter toute variante ou modification conforme à son esprit.

La présente invention peut être utilisée dans de nombreux domaines.

En particulier, on peut réaliser un capteur matriciel sensible dans la gamme visible ou infrarouge, utilisable dans le domaine de l'assistance à la conduite automobile nocturne, la dynamique importante obtenue conjointement à une grande sensibilité étant apte à assurer une très bonne qualité d'image en présence de sources éblouissantes dans le champ observé, telles que les projecteurs des véhicules roulant en sens inverse.

## Revendications

1. Photorécepteur, comprenant :
- une photodiode (PD) possédant une capacité de jonction (Cⱼ);
- des moyens (I_{clk}, V_{ref}) pour précharger ladite capacité de jonction en polarisant initialement la photodiode sous une tension inverse,
- des moyens (AO, C, I_{clk}, Iᵣₑₛₑₜ) d'acquisition d'une variable électrique (V_{Out}) représentative du courant produit dans la photodiode sous l'effet d'un rayonnement électromagnétique pendant une certaine durée d'exposition, et
- des moyens de cadencement (LC) pour commander les moyens de précharge et les moyens d'acquisition,
caractérisé en ce que ladite variable électrique (V_{Out}) résulte du courant produit dans la photodiode pendant une première phase au cours de laquelle la diode est polarisée en inverse et pendant une seconde phase, succédant à la première, au cours de laquelle la diode est polarisée en direct.

2. Photorécepteur selon la revendication 1, caractérisé en ce que les moyens de cadencement (LC) sont aptes à faire varier la durée d'exposition, de manière à faire varier la pente de ladite variable électrique (V_{Out}) en fonction de l'éclairement pendant ladite première phase.

3. Photorécepteur selon l'une des revendications 1 et 2, caractérisé en ce qu'il est prévu des moyens pour faire varier la tension de polarisation initiale (V_{ref}-V_{Nwell}), de manière à faire varier le niveau de la variable électrique (V_{Out}) en fonction de l'éclairement pendant ladite seconde phase.

4. Photorécepteur selon la revendication 3, caractérisé en ce que la photodiode est réalisée dans un caisson semi-conducteur (12) et en ce que les moyens pour faire varier la tension de polarisation initiale comprennent des moyens pour faire varier la tension de caisson (V_{Nwell}).

5. Photorécepteur selon l'une des revendications 1 à 4, caractérisé en ce que les moyens d'acquisition comprennent un circuit comportant :
un amplificateur (AO),
une capacité de mémorisation (C) branchée entre une entrée et la sortie de l'amplificateur,
un premier interrupteur commandé (Iᵣₑₛₑₜ) pour sélectivement court-circuiter les bornes de la capacité de mémorisation (C),
un second interrupteur commandé (I_{clk}) pour sélectivement relier la photodiode (PD) à ladite entrée de l'amplificateur, et
une source de tension de référence (V_{ref}) reliée à une autre entrée de l'amplficateur,
et en ce que ladite variable électrique (V_{Out}) est la tension de sortie dudit amplificateur.

6. Capteur photosensible matriciel, caractérisé en ce qu'il comprend une pluralité de photodétecteurs (P₀₀-P₃₁₃₁) selon l'une des revendications 1 à 5.

7. Capteur selon la revendication 6, caractérisé en ce que les photodétecteurs (P₀₀-P₃₁₃₁) sont organisés en lignes et en colonnes, et en ce qu'il comprend une pluralité de circuits d'acquisition (ACᵢ) respectivement associés aux photodétecteurs (Pᵢ₀-Pᵢ₃₁) de chacune des lignes, et un circuit d'adressage de colonne (BAC) destiné à affecter les circuits d'acquisition à des capteurs respectifs de chaque ligne appartenant à la même colonne.

8. Capteur selon l'une des revendications 6 et 7, caractérisé en ce que les circuits d'acquisition (ACᵢ) délivrent des tensions, et en ce qu'il comprend des moyens (Tᵢ) pour convertir lesdites tensions en courants.

9. Capteur selon la revendication 8, caractérisé en ce qu'il comprend un circuit convertisseur (AO') pour convertir les courants successifs délivrés par les moyens de conversion (Tᵢ) en tensions successives.

10. Capteur selon l'une des revendications 6 à 9, comprenant une pluralité de photodétecteurs selon la revendication 4, caractérisé en ce qu'il comprend des moyens pour faire varier une tension de caisson commune (V_{Nwell}) appliquée aux caissons des différents phododétecteurs.
